Europäisches Patentamt

European Patent Office

Office européen des brevets

(19)

(11) Publication number: **0 442 123 A1**

# EUROPEAN PATENT APPLICATION

(12)

(21) Application number: **90125120.7**

(22) Date of filing: **21.12.90**

(51) Int. Cl.5: **H01L 29/28**, H01L 31/0344, H01B 1/12

The title of the invention has been amended (Guidelines for Examination in the EPO, A-III, 7.3).

(30) Priority: **04.01.90 FI 900037**

(43) Date of publication of application:
**21.08.91 Bulletin 91/34**

(84) Designated Contracting States:
**AT BE CH DE DK ES FR GB GR IT LI LU NL SE**

(71) Applicant: **NESTE OY**
**Keilaniemi**
**SF-02150 Espoo(FI)**

(72) Inventor: **Gustafsson, Göran**
**Plommongatan 15**
**S-582 46 Linköping(SE)**
Inventor: **Inganäs, Olle**
**Wernersgatan 13**
**S-582 46 Linköping(SE)**
Inventor: **Sundberg, Mats**
**Paskliljevägen 86**
**S-722 46 Västeras(SE)**

(74) Representative: **Pellmann, Hans-Bernd,**
**Dipl.-Ing. et al**
**Patentanwaltsbüro**
**Tiedtke-Bühling-Kinne-Grupe-Pellmann-Grams, Bavariaring 4**
**W-8000 München 2(DE)**

(54) **Method for preparing electronic and electro-optical components and circuits based on conducting polymers.**

(57) The invention relates to a method for preparing electronic and electro-optical components and circuits based on conducting polymers. One or more boundary surfaces in the component between a conducting polymer and another material are formed by melting the conducting polymer.

FIG. 1

EP 0 442 123 A1

## METHOD FOR PREPARING ELECTRONIC AND ELECTRO-OPTICAL COMPONENTS AND CIRCUITS

The invention relates to electronic and electro-optical components and circuits based on conducting polymers.

It has been known for some time, how electronic components can be constructed by means of conducting conjugated polymers. For example, diodes in the form of Schottky-barriers between conducting polymers and metals have been studied in detail in the publication by J. Kanicki "Polymer Semiconductor Contacts and Photovoltaic Applications" in the Handbook of Conducting Polymers, Vol. 1,543 (1986), Ed. by T.A. Skotheim, and the studies of contacts between polymers and semiconductors have also been performed, e.g. by O.Inganäs, T. Skotheim and I Lundström, Phys. Scr. 25, 863 (1982) and by S Glenis and A.J. Frank, Synth. Met. 28, C715 (1989). The polymers studied have been prepared in the form of either thin films on a metallic, semiconducting or isolating substrate. As for the fact that a further contact point is necessary, this has been mounted by vacuum steaming a metal directly on the polymer surface. In some cases, the polymer has been directly electro-synthesized on the metal structure, which is constructed to be used as a field effect transistor, e.g. in the publication by A. Tsumura, H. Koezuka and T. Ando, Synth. Met 25, 11 (1988).

The polymers capable of being processed have lately been available and also utilized for the construction of polymer components. R. Friend in Cambridge has utilized a pre-polymer for a polyacetyle, which is formed into a thin film on a substrate. The polymer is then modified into a conducting polymer for the polyasetyle in a thermic phase. The contacts with this film placed therein through steaming can be used for forming polymer components, which has been shown e.g. by J.H. Burrouhges, C.A. Jones and R. H. Friend in the publication "Nature", 335, 137 (1988). It has been shown earlier (A. Assadi, C. Svensson, M. Willander and O. Inganäs, Appl. Phys. Lett. 53, 195 (1988), how thin films of poly(3-alkylthiophene) can be placed on completed structures for forming field effect transistors. For forming diodes, H. Tomozawa, D. Braun, S. Phillips, A.J Heeger and H. Kroemer, Synth. Met. 22, 63 (1987) need a contact with two separate metal surfaces, but this cannot be performed in a simple manner by means of the same technique as is used when constructing field effect transistors. The most simple way is to sputter or steam a metal film directly on the surface of the conducting polymer, which in turn is already located on another metal film.

It has now been found a new way of preparing components of conducting polymers. The method according to the invention is characterized in that one or more boundary surfaces in the component between a conducting polymer and another material are formed by melting the conducting polymer.

The preferred embodiments of the invention are presented in the subclaims.

It is thus shown in the present invention, how electronic components and circuits composed of components of the above-mentioned type can be realized by melting together a thin polymer film comprised of a meltable conducting polymer capable of processing in its neutral position between two surfaces comprised of metals, semiconductors or isolators. Different combinations provide different functions. A Schottky-barrier diode can for example be formed by melting the polymer between two different metals, a MESFET is formed by melting the polymer between two different surfaces with a metal pattern, an MIS capacitance is formed by melting the polymer between an isolator and a metal, and A MISFET transistor is formed by melting the polymer between a patterned metal film and an isolator surface. Circuits constructed with such components can naturally be realized by forming surfaces with metal films and isolator films for achieving the desired function. Solar cells can also be realized by using the same technique.

The advantages of the present invention are as follows:

1. A simple thermal stage is used for forming the boundary surface.

2. The polymer is not subjected to potent etching agents, since the geometry of the components and the circuits is formed by etching metal patterns on a substrate.

3. Is it possible to obtain in a simple manner boundary surfaces between the polymer and the material, which is not steamed, sputtered, cast or spun.

The invention is next described in detail with reference to the accompanying drawings, the purpose of which is not to limit the invention.

Fig. 1 is a principal scheme for preparing a Schottky-barrier structure in accordance with the method of invention.

Fig. 2 shows how the method according to the invention can be utilized for preparing a metal-semiconductor field effect transistor (MESFET) by melting the polymer between the two surfaces with a metal pattern

Fig. 3 shows how the method according to the invention can be used for preparing a Schottky-diode by melting the polymer between two surfaces with a metal pattern.

Fig. 4 shows how the method according to the invention can be used for preparing a metal-isolator semiconductor field effect transistor (MISFET) by melting the polymer between two surfaces with a metal pattern, one of which surfaces is covered by an isolating layer.

Fig. 5 shows how the method according to the invention can be used for preparing a metal-isolator semiconductor (MIS) capacitance by melting the polymer between two surfaces with a metal pattern, one of which surfaces is covered by an isolator layer.

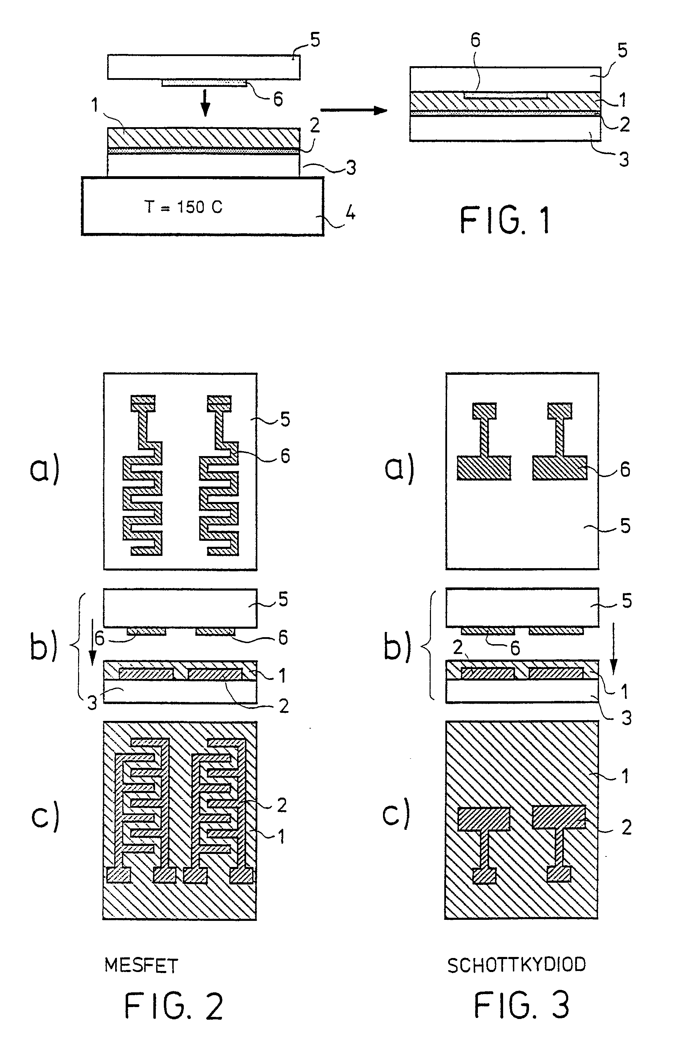

Fig. 1 shows an example of how a Schottky-barrier structure, such as Au/P30T/Al, can be prepared according to the method of the invention.

1. A P30T film 1 is cast from a P30T/CHCl$_3$ solution (30 mg/ml) on a substrate comprised of Al (aluminum) 2 steamed on a glass 3.

2. The structure is placed on the heating plate 4. A glass substrate, on which gold is steamed at a point located in the middle, is placed on the P30T film 1. This "sandwich structure" is heated until P30T starts to soften, whereby the structure is pressed together in such a way that a relatively thick (e,g, 15-20 $\mu$m) and a homogenous P30T layer 1 is obtained, which is in contact with the two metals.

3. The "sandwich structure" is taken away from the heating plate 4, and it is allowed to cool down to room temperature.

In Fig. 2, is prepared a metal-semiconductor field effect transistor (MESFET) according to the invention. A meltable polymeric layer 1 is cast on a substrate 3, on which a metal pattern 2 is steamed according to a method of Fig. 2c. The metal to be used is to have an ohmic contact with the polymer. Another substrate 5, on which is steamed a pattern of another metal 6 according to the method according to Fig. 2a is placed against the polymer layer 1 from the other side of Fig. 2b. The metal to be used is to give a unidirectional contact with the polymer. The "sandwich structure" is heated and completed in the same way as in Fig. 1.

In Fig. 3, a Schottky-diode is prepared in the same way as in Fig. 2. A meltable polymer layer 1 is cast on a substrate 3, on which a metal pattern 2 is steamed according to the method of Fig. 3c. The metal to be used in this connection gives an ohmic contact with the polymer.

Another substrate 5, on which a pattern of another metal 6 is steamed according to the method of Fig. 3a is placed against the polymer layer 1 from the other side according to Fig. 3b. The metal to be used gives a unidirectional contact with the polymer. The "sandwich structure" is heated and completed according to the method of Fig. 1.

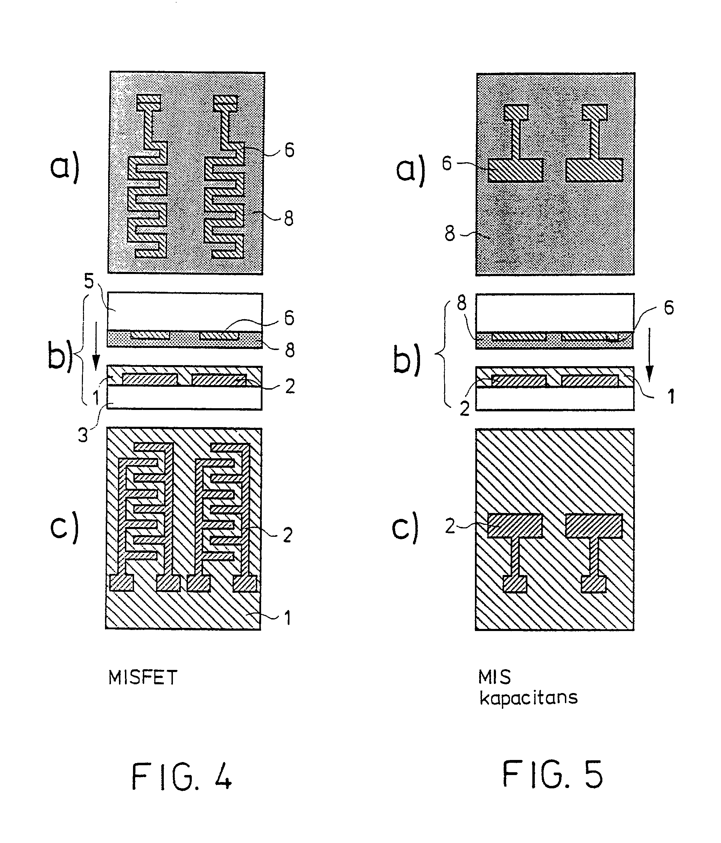

In Fig. 4, a metal-isolator-semiconductor field effect transistor MISFET is prepared according to the method of the invention. A meltable polymer layer 1 is cast on a substrate 3, on which a metal pattern 2 is steamed according to the method of Fig. 4c. The metal to be used gives an ohmic contact with the polymer. Another substrate 5, on which a pattern of another metal 6 is steamed according to the method of Fig. 4a and which is then covered with a layer of another isolating material 8, is placed against the polymer layer 1 from the other side according to Fig. 4b. The "sandwich structure" is heated and completed in the same way as in Fig. 1.

In Fig. 5, a metal-isolator-semiconductor (MIS) capacitance is prepared according to the method of Fig. 4. A meltable polymer layer 1 is cast on a substrate 3, on which a metal pattern 3 is steamed according to the method of Fig. 5c. The metal to be used gives an ohmic contact with the polymer. Another substrate 5, on which a pattern of another metal 6 is steamed according to the method of Fig. 5a and which is then covered with a layer of another isolating material 8, is placed against the polymer layer 1 from the other side according to Fig. 5b. The "sandwich structure" is heated and completed in the same way as in Fig. 1.

The obvious advantages to be obtained by means of the new preparation method are as follows:

1) It is not necessary to subject the polymer to powerful etching agents, which are conventionally used for etching the metal pattern.

2) It is possible to obtain in a simple manner boundary surfaces between P2AT and the material that does not start to spin, steam or sputter. For example Au/P3AT/Au (it is, among other things, difficult to steam gold, since gold easily diffuses through P3AT) or optical components of the type Glass/ITO/Isolator/ P3AT/Glass.

The patent claims within the scope of which the details of the invention can vary are presented next.

The invention relates to a method for preparing electronic and electro-optical components and circuits based on conducting polymers. One or more boundary surfaces in the component between a conducting polymer and another material are formed by melting the conducting polymer.

## Claims

1. A method for preparing electronic and electro-optical components and circuits based on conducting polymers, **characterized** in that one or more boundary surfaces in the component between a conducting polymer and another material are formed by melting the conducting polymer.

2. A method according to Claim 1, **characterized** in that a boundary surface between a conducting polymer and a metal is formed by pressing the two surfaces against each other under heat in such a way that the materials are fixed against each other.

3. A method according to Claim 1, **characterized** in that a boundary surface between a conducting polymer and an isolator is formed by pressing the two surfaces against each other under heat in such a way that the materials are fixed against each other.

4. A method according to Claim 1, **characterized** in that a boundary surface between a conducting polymer and a semiconductor is formed by pressing the two surfaces against each other under heat in such a way that the materials are fixed against each other.

5. A method according to Claim 2, **characterized** in that the metal is any of metals in the periodic system, preferably Au, Cr, Ti, In, Pt.

6. A method according to Claim 3, **characterized** in that the isolator is an inorganic or polymeric isolator.

7. A method according to Claim 4, **characterized** in that the semiconductor comprises Si, an amorphous silicon hydride (a-Si:H), GaAs, CuInSe or a polymer semiconductor.

8. A method according to any of the Claims 1-7, **characterized** in that the conducting polymer is a meltable poly(3-octylthiophene), poly(3-alkylthiophene), poly(alkylthiophene vinyl), polyalkylpyrrolidine or the like.

FIG. 1

a)

b)

c)

MESFET

FIG. 2

a)

b)

c)

SCHOTTKYDIOD

FIG. 3

a)

b)

c)

MISFET

FIG. 4

a)

b)

c)

MIS
kapacitans

FIG. 5

European
Patent Office

EUROPEAN SEARCH
REPORT

Application Number

EP 90 12 5120

# DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 084 330  (BAYER)<br>* pages 2,6-9; claim 7 * | 1-3,5,6 | H 01 L 29/28<br>H 01 L 31/0344<br>H 01 B 1/12 |
| Y | | 8 | |
| X | PATENT ABSTRACTS OF JAPAN vol. 13, no. 155 (E-743), 14 April 1989;<br>& JP - A - 63313413 (HITACHI) 21.12.1988<br>* the whole document * | 1,3,6 | |
| X | PATENT ABSTRACTS OF JAPAN vol. 10, no. 224 (E-425), 5 August 1986;<br>& JP - A - 61061475 (TOYOTA) 29.03.1986<br>* the whole document * | 1,4,7 | |
| D,Y | SYNTHETIC METALS vol. 22, 1987, pages 63-69, Elsevier Sequoia, NL; H. TOMOZAWA et al.: "Metal-polymer Schottky barriers on cast films of soluble poly(3-alkylthiophenes)"<br>* pages 63,64 * | 8 | |
| D,A | NATURE vol. 335, 8 September 1988, pages 137-141, London, GB; J.H. BURROUGHES et al.: "New semiconductor device physics in polymer diodes and transistors"<br>* the whole document * | 1-8 | TECHNICAL FIELDS SEARCHED (Int. Cl.5)<br><br>H 01 L<br>H 01 B |
| A | JAPANESE JOURNAL OF APPLIED PHYSICS vol. 22, no. 2, part 1, February 1983, pages 348-350, Tokyo, JP; S. KANAYAMA et al.: "Formation of MIS structure in organic cell Al/Pb-Phthalocyanine/ITO"<br>* the whole document * | 1,2,4 | |
| A | JOURNAL OF APPLIED PHYSICS vol. 58, no. 3, August 1985, pages 1279-1284, Woodbury, New York, US; H. KOEZUKA et al.: "Organic heterojunctions utilizing two conducting polymers:Poly(acetylene)/poly(N-methylpyrrole)junctions"<br>* the whole document * | 1,4,7 | |

The present search report has been drawn up for all claims

| Place of search | Date of completion of search | Examiner |
|---|---|---|
| Berlin | 27 March 91 | MUNNIX S J G |

CATEGORY OF CITED DOCUMENTS
X : particularly relevant if taken alone
Y : particularly relevant if combined with another document of the same category
A : technological background
O : non-written disclosure
P : intermediate document
T : theory or principle underlying the invention

E : earlier patent document, but published on, or after the filing date
D : document cited in the application
L : document cited for other reasons

......................................................................

& : member of the same patent family, corresponding document